# EUROPEAN PATENT SPECIFICATION

(11) **EP 4 020 811 B1**
(45) Date of publication and mention of the grant of the patent: **07.06.2023**
(21) Application number: 20217010.6
(22) Date of filing: 23.12.2020
(51) Int. Cl.: H03L 7/08, H04B 5/00, H04W 52/02, H03L 7/183

(54) **POWER-ON COMMUNICATION BETWEEN A HOST IC AND A CLIENT IC**
EINSCHALT-KOMMUNIKATION ZWISCHEN HOST-IC UND CLIENT-IC
COMMUNICATION DE MISE SOUS TENSION ENTRE UN CI HÔTE ET UN CI CLIENT

(43) Date of publication of application: 29.06.2022
(73) Proprietor: Panthronics AG, 8041 Graz (AT)
(72) Inventor: Jongsma, Jakob, 8041 Graz (AT); Felicijan, Tomaz, 8041 Graz (AT); Pieber, Michael, 8041 Graz (AT)
(74) Representative: Schwarz & Partner Patentanwälte GmbH

(56) References cited:
- US-A1- 2013 295 843
- US-A1- 2018 110 018
- US-A1- 2018 145 763

## Description

### FIELD OF THE INVENTION

The present invention relates to a system of a Host IC connected via a wired data interface to a Client IC to initiate the communication between the Host IC and the Client IC after power-on, wherein the Client IC comprises a PLL stage with a closed loop of a phase detector a filter and a voltage controlled oscillator for the generation of the clock for the Client IC, which PLL stage needs to be locked to the clock of the Host IC for regular data communication via the wired data interface.

### BACKGROUND OF THE INVENTION

A Universal Asynchronous Receiver Transmitter also named as UART Interface is used for a wired data communication between devices or between integrated circuits within a system or device. For a UART communication, the data rate must be quite accurate. A maximum deviation of less than +/- 5% for both communicating peers must be guaranteed in order to have a successful communication, leading to a maximum of less than +/- 2.5% on each device. Practically the value should be even better to have some margin against any disturbance on the line and alike.

To guarantee stable UART communication at startup, state of the art devices need a very accurate clock source, which has to be available already at boot time after power-on in combination with either a fixed baud rate, a pin-configurable baud rate or some kind of baud rate detection. The need for an accurate clock source already at startup adds design complexity. This means that an accurate oscillator must be present on chip or an expensive accurate source must be there and/or effort for chip initialization by e.g. trimming an oscillator at final test and setup of the device for certain use-cases has to be done. Such state of the art integrated circuits are for instance AN635 from Silicon Labs or MPC8280RM from NXP.

To avoid the need for an accurate clock source in a Client IC integrated cirucuit connected via a wired data interface to a Host IC integrated circuit, the use of a phase lock loop PLL stage is known. The PLL stage comprises a phase detector to detect the phase difference between the clock provided by a Host IC and the clock generated by a voltage controlled oscillator. The detection signal passes a filter and then regulates the clock generated by the voltage controlled oscillator in a loop until both clocks of the Host IC and the clock generated by the PLL stage for the Client IC are locked. This process to lock both clocks has to be done after power-on to enable a regual data communication via the wired data interface like the UART interface. If the Client IC is an interface IC to communicate via a wireless data interface like Near Field Communication NFC with another NFC device, the clock generated by the PLL stage of the Client IC needs to be locked to the accurate clock of the Host IC as well before wireless communication may start. This accurate clock in the Client IC is needed in enbodiments where the Host IC is a Host IC of e.g. an ATM and the Client IC is an NFC interface IC in the ATM to enable a wireless NFC payment application. The accurate clock of the NFC interface IC in this embodiment is needed to generate the standard conform carrier frequency of 13,56MHz for the RF-field. Therefore, the use of a PLL stage in such a Client IC has the disadvantage that the time period for power-on of the Client IC is extended by the time period to lock the internal clock of the Client IC to the clock of the Host IC using the PLL stage. This extended time period for power-on is a dissadavntage in some embodiments like payment applications with battery powered ATMs that switch off the NFC interface IC after each payment to save power of the batteries and that have to power-on the NFC interface IC for each new payment application.

It is a further dissadvantage that the clock system of the Client IC needs to be defined and fixed upfront. This means that e.g. known Client ICs need to know the clock frequency of the Host IC or the use of an crystal oscilator upfront. This information needs to be stored in an non-volatile memory what adds consts to the device.

The patent application publication US2018145763 A1 discloses a communication device used for near field communication (NFC) including a phase synchronizer to selectively operate in a closed loop mode and in an open loop mode to generate an output signal based a signal received from a communication partner device.

### SUMMARY OF THE INVENTION

It is an object of the invention to provide a system of a Host IC and a Client IC with a PLL stage for internal clock generation to initiate the communication between the Host IC and the Client IC after power-on within a very short time period in a flexible and versatile way.

This object is achieved in a system with a Client IC that comprises a power-on stage to steer a switch in the connection between the input of the clock of the Host IC for the PLL stage and the voltage controlled oscillator of the PLL stage to open the connection and to use the unregulated output clock of the free-running voltage controlled oscillator in a time period after power-on for a power-on data communication via the wired data interface and to close the switch after that time period for regular data communication.

This inventive concept enables a communication between the Host IC and the Client IC after power-on without the need for an accurate clock in the Client IC or Host IC. There is no need to wait until the PLL stage of the Client IC locked to the clock of the Host IC and there is a lot flexibility for the Host IC to fix the clock of the Client IC for different applications with different frequencies. In principle, the Host IC and the Client IC could process their complete communication based on this concept to use the unregulated output clock of the voltage controlled oscillator in the Client IC. In a preferred embodiment only configuration data are sent by the Host IC during this first period of a power-on data communication immediately after power-on and received by the Client IC to configure the Client IC to lock the clocks of the Host IC and the Client IC. With these configuration data the PLL stage and maybe other stages of the Client IC are configured and the power-on stage closes the loop of the PLL stage with the switch to enable the regular data communication with locked clocks of the Host IC and the Client IC in a second period of communication. Hence the system is versataile and does not need any trimming or upfront configuration.

In a preferred embodiment of the invention, a UART communication is initialized between the Host IC and the Client IC. Automatic baud rate detection systems are known to a person skilled in the art that are used by the Client IC to detect with which baud rate the Host IC uses for the UART communication. Such automatic baud rate detection systems only work after the internal clocks of both ICs are locked. The inventive concept works even before the clocks are locked as the unregulated output clock of PLL stage of the Client IC is used to measure the duration of the start bit, that is part of the initial UART communication in a so called sync pattern. This duration of the start bit is measured by counting the number of clock cycles of the unregulated output clock of the PLL stage between the first falling edge of the start bit after power-on and the rising edge of the start bit. Other special bit patterns comprising several bits could be used as well as long the Host IC and the Client IC know which special bit pattern to send or receive. A decoder stage of the Client IC receives such duration of one bit sent by the Host IC and uses this as reference to decode further information received during power-on data communication like the configuration data sent by the Host IC. This inventive concept therefore enables a short power-on time duration until the system is up and running and is very robust against disturbances and errors. Furthermore, with this mechanism of using the "free-running VCO" any other kind of communication scheme (e.g. SPI, I2C, ...) can be used as well. Additionally the Host IC is free to chose differenc clock systems or frequencies depending on the application the Host IC needs to process with the Client IC.

These and other aspects of the invention will be apparent from and elucidated with reference to the embodiments described hereinafter. The person skilled in the art will understand that various embodiments may be combined.

### BRIEF DESCRIPTION OF THE DRAWINGS

Figure 1 shows a system of a Host IC connected via a UART wired interface with a Client IC.
Figure 2 shows a power-on stage and a PLL stage of the Client IC of figure 1.
Figure 3 shows a sync pattern that starts with a start bit.
Figure 4 shows the measurement of the duration of the start bit by the power-on stage.
Figure 5 shows the baud rate detection.

### DETAILED DESCRIPTION OF EMBODIMENTS

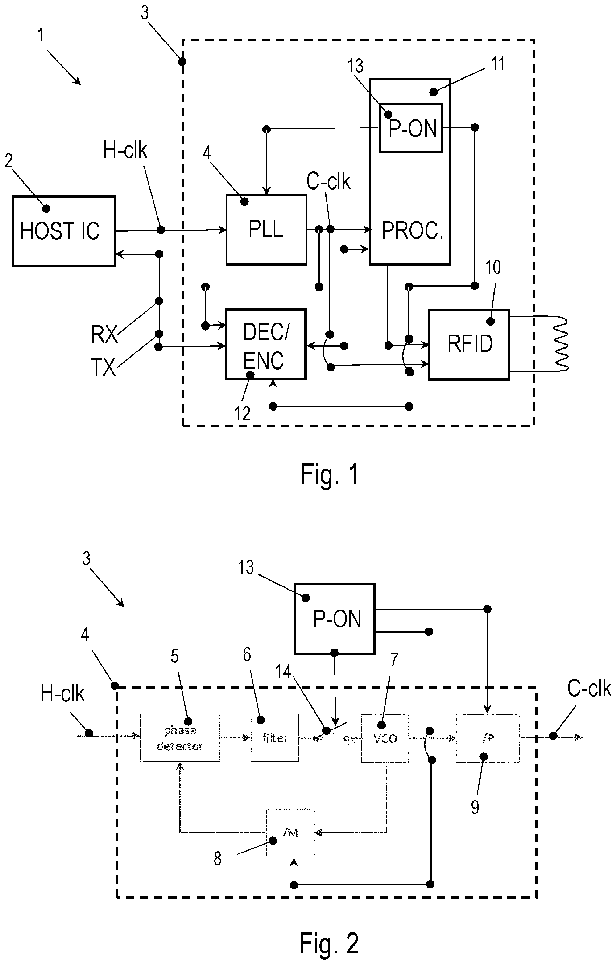

Figure 1 shows a system 1 of a Host IC 2 connected via a wired data interface to a Client IC 3 to initiate the communication between the Host IC 2 and the Client IC 3 after power-on. In this first embodiment of the invention system 1 is part of a mobile phone wherein the Host IC 2 is the processor of the mobile phone and the Client IC 3 is an integrated circuit to enable wireless communication based on the NFC standard that complies with the international standard ISO 18.092. In other embodiments of the invention system 1 could be part of an RFID reader or an EMVCo payment terminal.

Client IC 3 could comprise an RC-oscillator that needs to be trimmed during production of Client IC 3 or could use a cost expensive crystal oscillator to generate an internal clock C-clk. Instead, Client IC 3 comprises a PLL stage 4 to generate the internal clock C-clk with a particular frequency and phase that needs to be locked to the frequency and phase of the internal clock H-clk of the Host IC 2. Figure 2 shows PLL stage 4 in detail which comprises a closed loop of a phase detector 5 and a filter 6 and a voltage controlled oscillator 7. The loop is closed by a connection from the output of the voltage controlled oscillator 7 to an input of the phase detector 5, in which connection a first pre-divider 8 is integrated, which divides the clock signal at the output of the voltage controlled oscillator 7 by a factor M. This means the first pre-divider 8 decreases the clock frequency from the voltage controlled oscillator by factor M what is an integer number like for instance 10, 100 or 1.000. The clock signal of the output of the voltage controlled oscillator 7 passes a second pre-divider 9 which provides the internal clock C-clk as output signal of the PLL stage 4. The second pre-divider 9 decreases the clock frequency from the voltage controlled oscillator by factor P what is an integer number like 10, 100 or 1.000. The first pre-divider 8 and the second pre-divider 9 are used to adjust the frequency of the internal clock C-clk of Client IC 3, which internal clock C-clk is phase locked to the internal clock H-clk of the Host IC 2 by PLL stage 4.

The internal clock H-clk of the Host IC 2 and the internal clock C-clk of the Client IC 3 need to be locked before a regular data communication via the wired data interface may be started. In this embodiment of the invention the wired data interface is realized as a Universal Asynchronous Receiver Transmitter also named UART Interface, which in general is used for a wired data communication between devices or between integrated circuits within a system or device. For a UART communication, the data rate must be quite accurate. A maximum deviation of less than +/- 5% for both communicating peers must be guaranteed in order to have a successful communication, leading to a maximum of less than +/- 2.5% on each device. Practically the value should be even better to have some margin against any disturbance on the line and alike.

As Client IC 3 is an integrated circuit to enable wireless communication via a NFC interface based on the NFC standard for the mobile phone, Client IC 3 furthermore comprises RFID stage 10 to transmit and receive data provided by a processor 11 of Client IC 3 in a way defined in standard ISO 18.092. RFID stage 10 and processor 11 both receive the internal clock C-clk of Client IC 3 from PLL stage 4. A decoder/encoder stage 12 of Client IC 3 is connected to processor 11 and via a data line of the UART interface to Host IC 2 to exchange data to be transmitted via the wireless NFC interface with RFID stage 10.

After power on of the mobile phone, both the Host IC 2 and the Client IC 3 are powered and the baud rate to exchange data via the UART Interface needs to be fixed first before a regular data communication based on the UART specification may be started. As different applications may be realized depending on the features of the mobile phone and as Client IC 3 does not comprise a none-volatile memory to store such configuration data about the baud rate to be used, this internal clock H-clock frequency and baud rate used by Host IC 2 needs to be detected by Client IC 3. This is particular relevant in embodiments of the invention where Host IC and Client IC are not part of the same device. This provides the advantage that the clock generation does not need to be selected upfront.

To enable to lock the internal clock C-clk of Client IC 3 to the internal clock H-clk of Host IC 2 and to enable a power on data communication, Client IC 3 furthermore comprises a power-on stage 13 as part of processor 11 to steer a switch 14 in the connection between the input of the phase detector 5, where the phase detector 5 is connected to the clock H-clk of the Host IC 2, and the voltage controlled oscillator 7 of the PLL stage 4. "*In the connection*" has to be interpreted in a way that switch 14 may be realized at the input of the clock H-clk of the Host IC 2 of the phase detector 5 or between the phase detector 5 and the filter 6 or, as shown in figure 2, between filter 6 and voltage controlled oscillator 7 or, if no filter 6 is realized, directly between phase detector 5 and voltage controlled oscillator 7. This switch 14 could be realized by the phase detector 5 as well, if the output impedance of the phase detector 5 is change to high, clock H-clk of the Host IC 2 does not change the input signal of the voltage controlled oscillator 7. Switch 14 therefore is realized to open the connection between the input of phase detector 5 and voltage controlled oscillator 7 and to use the unregulated output clock of the free-running voltage controlled oscillator 7 in a time period after power-on for the power-on data communication via the wired UART interface or even for a wired data communication after this time period.

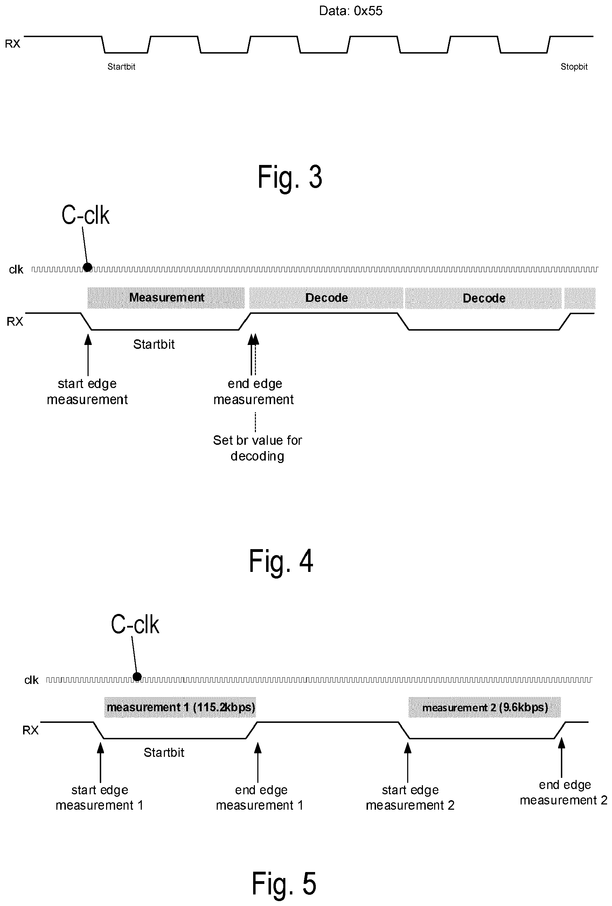

During that time switch 14 is opened, voltage controlled oscillator 7 generates a stable clock with a frequency potentially significantly off its nominal frequency (e.g. +/- 25). This stable internal clock C-clk of Client IC 3 can be used to measure the duration of the length of one or more bits sent by Host IC 2. Figure 3 shows a data byte RX with the value 0x55 sent by Host IC 2 after power-on with a start bit and a stop bit as defined in UART communication, which data byte RX is received and decoded in the decoder/encoder stage 12 and provided to processor 11. Figure 4 shows this unregulated, but stable internal clock C-clk of Client IC 3, which is provided to the processor 11 to measure the duration of the start bit sent by the Host IC 2 during the power-on data communication with decoder/encoder stage 12 controlled by the power-on stage 13. Power-on stage 13 is connected with decoder/encoder stage 12 and starts decoder/encoder stage 12 to count the number of clock cycles of the internal clock C-clk with the falling edge of the start bit and decoder/encoder stage 12 stops the measurement of the duration of the length of one bit at the rising edge of the start bit as can be seen in figure 4. As soon as Client IC 3 knows the duration of one single bit sent by Host IC 2, communication of data and in particular of configuration data from the Host IC 2 to the Client IC 3 is possible as encoder/decoder stage 12 is enabled to decode received data RX and to encode data TX to be transmitted to the Host IC 2. In this embodiment of the invention configuration data to configure Client IC 3 are transmitted from the Host IC 2 to Client IC 3 during the power-on data communication. These configuration data comprise information how to set factor M for the first pre-divider 8 and how to set factor P for the second pre-divider 9 and how to lock the PLL stage 4 with high accuracy to the internal clock H-clk of Host IC 2. To achieve that the input frequency of the clock H-clk needs to be known, which information is part of the configuration data. These configuration data could be used as well to trim an RC oscillator of Client IC 3 or to select a crystal oscillator as reference clock or how to pre-process a selected reference clock. Furthermore Client IC 3 for example could allow the use of a set of input frequencies or even be able to handle any frequency in a certain range as PLL reference. After that, power-on stage 13 closes switch 14 again and Client IC 3 is configured for the regular data communication according to the UART specification via the UART interface with Host IC 2 and for the wireless communication with other devices via RFID stage 10. Regular data communication is meant to be a data communication that is possible after the internal clocks are locked and the baud rate has been confirmed between the communicating ICs.

In another embodiment of the invention the data communication between Host IC 2 and Client IC 3 could be processed not only during the power-on communication, but also for further data communication with switch 14 open and based on the unregulated, but stable internal clock C-clk of Client IC 3.

In the embodiment of the invention shown in figure 5 this power-on data communication with open switch 14 is used for the baud rate detection of the baud rate used by Host IC 2 as well. Normal baud rate detection mechanisms use an accurate internal clock C-clk to identify an unknown baud rate. The inventive method doesn't need an accurate internal clock C-clk as it just adjusts to the used baud rate, but does not set an absolute baud rate.

To work correctly the communication protocol needs the Host IC 2 to send a sync pattern. In the easiest case this sync is data byte RX with the value 0x55 as shown in figure 3 as the pattern results in a sequence of alternating low/high values on the line, which is optimal for calculating the frequency. However, every fixed pattern can be used - e.g. it would be theoretically possible to include the sync bit as first bit into the protocol header.

Based on the invention for some use cases the system 1 may be optimized. A prescaler in the UART baud rate generation is used for baud rate detection, at the first falling edge the prescaler is set to determine the number of (prescaler) cycles for a baud rate of 115.2kbps (a UART default data rate) and the counter in processor starts counting. It is saturated to void overflows and consequently incorrect detection.

As shown in figure 5, when detecting the rising edge of the data byte RX the counter value is compared against two thresholds, an upper threshold and a lower threshold. If the counted value is within the two thresholds the baud rate used by the Host IC 2 is 115.2kbps. In case the value is higher than the upper threshold, the baud rate is slower. In that case the prescaler is configured for the lower baud rate and mechanism is armed again. At detection of the next falling edge, the counter is started again as described above. If the second run leads to a value within the thresholds, the data rate 9.6kbps is used by the Host IC 2.

If the value is lower, than the lower threshold then the baud rate is higher, communication is not possible. Theoretically, an attempt to detect the higher baud rate could be taken as described for the lower baud rate. After the end of the detection the remaining bits of the sync pattern are checked to validate the detected baud rate.

This inventive system and method to use the unregulated output clock of the free-running voltage controlled oscillator 7 of the PLL stage 4 in a time period after power-on for a power-on data communication via the wired data interface or even for a data communication thereafter enables secure and always possible communication between the Host IC 2 and the Client IC 3 even if the internal clocks are not locked and the baud rate to be used has not been confirmed.

In another embodiment of the invention Client IC could comprises a wireless data interface that complies to Bluetooth @ or UWB or any similar other wireless data interface.

## Claims

1. System (1) of a Host IC (2) connected via a wired data interface to a Client IC (3) to initiate the communication between the Host IC (2) and the Client IC (3) after power-on, wherein the Client IC (3) comprises a PLL stage (4) with a closed loop of a phase detector (5) a filter (6) and a voltage controlled oscillator (7) for the generation of the clock (C-clk) for the Client IC (3), which PLL stage (4) needs to be locked to the clock (H-clk) of the Host IC (2) for regular data communication via the wired data interface, which system (1) is **characterized in,**
**that** the Client IC (3) comprises a power-on stage (13) to steer a switch (14) in the connection between the input of the clock (H-clk) of the Host IC (2) for the PLL stage (4) and the voltage controlled oscillator (7) of the PLL stage (4) to open the connection and to use the unregulated output clock of the free-running voltage controlled oscillator (7) in a time period after power-on for a power-on data communication via the wired data interface and to close the switch (14) after that time period for regular data communication.

2. System (1) according to claim 1, wherein the power-on stage (13) is built to control a decoder/encoder stage (12) to use the unregulated output clock to measure the duration of a bit information sent by the Host IC (2) during power-on data communication and to use the measured duration to receive configuration data from the Host IC (2) during the power-on data communication and to use the configuration data to configure the Client IC (3) and in particular the PLL stage (4) for the regular data communication with the closed switch (14) of the PLL stage (4).

3. System (1) according to claim 2, wherein the configuration data are used to set the ratio of a frequency divider (8) in the loop between the voltage controlled oscillator (7) and the phase detector (5) and/or to set the ratio of a frequency divider (9) of the output clock of the voltage controlled oscillator (7) and/or to trim an oscillator of the Client IC (3) and/or to select a reference clock and/or for pre-processing of a selected reference clock.

4. System (1) according to any of the claims 1 to 3, wherein the wired data interface is realized as UART and the power-on stage (13) is built to detect the first falling or rising edge of the start bit or any other special bit pattern during power-on data communication and to count the number of clock cycles of the unregulated output clock (C-clk) until the rising or falling edge of the start bit or special bit pattern which counted number of clock cycles are used as reference for the bit length or special bit pattern length by a decoder/encoder stage (12) of the Client IC (3) to decode the configuration data received after the start bit or the special bit pattern and/or to encode data to be transmitted to the Host IC (2) during the power-on data communication.

5. System (1) according to claim 4, which power-on stage (13) is built to compare the counted number of clock cycles with an upper threshold and a lower threshold for each of a number of possible baud rates to detect the baud rate used by the Host IC (2) and to set the detected baud rate in the Client IC (3).

6. System (1) according to claim 1, which power-on stage (13) is built to steer the switch (14) open and to use the unregulated output clock of the free-running voltage controlled oscillator (7) even after the power-on data communication for at least part of the following data communication via the wired data interface.

7. System (1) according to any of the claims 1 to 6, wherein the Client IC (3) comprises a wireless data interface (10) to communicate with another device, which wireless communication starts only after the switch (14) has been closed again and the clock (C-clk) of the Client IC (3) has been set by the power-on stage (13).

8. System (1) according to claim 6, which wireless data interface (10) is realized as NFC interface that complies with the standard ISO 18.092.

9. Method to initialize a regular data commmunication between a Host IC (2) connected via a wired data interface to a Client IC (3) after power-on, which Client IC (3) comprises a PLL stage (4) with a closed loop of a phase detector (5) a filter (6) and a voltage controlled oscillator (7) to generate the clock (C-clk) for the Client IC (3), which PLL stage (4) needs to be locked to the clock (H-clk) of the Host IC (2) for regular data communication via the wired data interface, which method comprises the following steps:
- Provide power to the Host IC (2) and the Client IC (3);
- Use the unregulated output clock (C-clk) of the free-running voltage controlled oscillator (7) in a time period after power-on for a power-on data communication via the wired data interface to receive configuration data from the Host IC (2);
- Use the configuration data to configure the Client IC (3) to lock the clock of the Host IC (2) and the Client IC (3) for regular data communication after that time period.

10. Method according to claim 9, wherein the power-on data communication comprises the following steps:
- Measure the duration of a bit information sent by the Host IC (2) with the unregulated output clock (C-clk) during power-on data communication;
- Use the measured duration to receive configuration data from the Host IC (2) during power-on data communication;
- Configure the Client IC (3) and in particular the PLL stage (4) for the regular data communication.

## Patentansprüche

1. System (1) eines Host-IC (2), der über eine verdrahtete Daten-Schnittstelle mit einem Client-IC (3) verbunden ist, um die Kommunikation zwischen dem Host-IC (2) und dem Client-IC (4) nach dem Einschalten zu initiieren, wobei der Client-IC (4) eine PLL-Stufe (4) mit einer geschlossenen Schleife eines Phasendektors (5), einen Filter (6) und einen spannungsgesteuerten Oszillator (7) für die Erzeugung des Takts (C-clk) für den Client-IC (4) umfasst, wobei die PLL-Stufe (4) mit dem Takt (H-clk) des Host-IC (2) für die reguläre Datenkommunikation über die verdrahtete Datenschnittstelle gesperrt sein muss, wobei das System (1) **dadurch gekennzeichnet ist,**
**dass** der Client-IC (3) eine Einschaltstufe (13) umfasst, um einen Schalter (14) in der Verbindung zwischen der Eingabe des Takts (H-clk) des Host-IC (2) für die PLL-Stufe (4) und dem spannungsgesteuerten Oszillator (7) der PLL-Stufe (4) dahin zu lenken, die Verbindung zu öffnen und den unregulierten Ausgabetakt des frei laufenden spannungsgesteuerten Oszillators (7) in einer Zeitspanne nach dem Einschalten für eine Einschalt-Datenkommunikation über die verdrahtete Datenschnittstelle zu verwenden und den Schalter (14) nach dieser Zeitspanne für die reguläre Datenkommunikation zu schließen.

2. System (1) gemäß Anspruch 1, wobei die Einschaltstufe (13) dazu ausgelegt ist, eine Decodierer-/Codiererstufe (12) zu steuern, um den unregulierten Ausgabetakt zu verwenden, um die Dauer einer Bit-Information, die von dem Host-IC (2) während der Einschalt-Datenkommunikation gesendet wird, zu messen und die gemessene Dauer zu verwenden, um Konfigurationsdaten von dem Host-IC (2) während der Einschalt-Datenkommunikation zu empfangen und die Konfigurationsdaten zu verwenden, um den Client-IC (3) und insbesondere die PLL-Stufe (4) für die reguläre Datenkommunikation mit dem geschlossenen Schalter (14) der PLL-Stufe (4) zu konfigurieren.

3. System (1) gemäß Anspruch 2, wobei die Konfigurationsdaten dazu verwendet werden, um das Verhältnis eine Frequenzteilers (8) in der Schleife zwischen dem spannungsgesteuerten Oszillator (7) und dem Phasendetektor (5) festzulegen und/oder das Verhältnis eines Frequenzteilers (9) des Ausgabetakts des spannungsgesteuerten Oszillators (7) festzulegen und/oder einen Oszillator des Client-IC (3) anzupassen und/oder einen Referenztakt auszuwählen und/oder um einen ausgewählten Referenztakt vorzuverarbeiten.

4. System (1) gemäß einem beliebigen der Ansprüche 1 bis 3, wobei die verdrahtete Datenschnittstelle als ein UART umgesetzt ist und die Einschaltstufe (13) dazu ausgelegt ist, die erste abfallende oder ansteigende Kante des Start-Bits oder eines beliebigen anderen speziellen Bitmusters während der Einschalt-Datenkommunikation zu detektieren und die Anzahl an Taktzyklen des unregulierten Ausgabetakts (C-clk) bis zur ansteigenden oder abfallenden Kante des Start-Bits oder eines speziellen Bitmusters zu zählen, wobei die gezählte Anzahl von Taktzyklen als Referenz für die Bitlänge oder die Länge des speziellen Bitmusters durch eine Decodierer-/Codiererstufe (12) des Client-IC (3) verwendet wird, um die Konfigurationsdaten zu decodieren, die nach dem Start-Bit oder dem speziellen Bitmuster erhalten wurden, und/oder Daten, die an den Host-IC (2) während der Einschalt-Datenkommunikation zu übertragen sind, zu codieren.

5. System (1) gemäß Anspruch 4, wobei die Einschaltstufe (13) dazu ausgelegt ist, die gezählte Anzahl an Taktzyklen mit einer Obergrenze und einer Untergrenze für jede einer Anzahl möglicher Baud-Raten zu vergleichen, um die Baud-Rate zu detektieren, die von dem Host-IC (2) verwendet wird, und um die detektierte Baud-Rate in dem Client-IC (3) festzulegen.

6. System (1) gemäß Anspruch 1, wobei die Einschaltstufe (13) dazu ausgelegt ist, den Schalter (14) dahin zu lenken, sich zu öffnen und den unregulierten Ausgabetakt des freilaufenden spannungsgesteuerten Oszillators (7) sogar nach der Einschalt-Datenkommunikation für zumindest einen Teil der folgenden Datenkommunikation über die verdrahtete Datenschnittstelle zu verwenden.

7. System (1) gemäß einem beliebigen der Ansprüche 1 bis 6, wobei der Client-IC (3) eine drahtlose Datenschnittstelle (10) umfasst, um mit einer anderen Vorrichtung zu kommunizieren, wobei die drahtlose Kommunikation erst startet, nachdem der Schalter (14) erneut geschlossen wurde und der Takt (C-clk) des Client-IC (3) durch die Einschaltstufe (13) festgelegt wurde.

8. System (1) gemäß Anspruch 6, wobei die drahtlose Datenschnittstelle (10) als eine NFC-Schnittstelle ausgeführt ist, die dem Standard ISO18.092 entspricht.

9. Verfahren, um eine reguläre Datenkommunikation zwischen einem Host-IC (2), der nach dem Einschalten über eine verdrahtete Datenschnittstelle mit einem Client-IC (3) verbunden ist, wobei der Client-IC (3) eine PLL-Stufe (4) mit einer geschlossenen Schleife eines Phasendetektors (5), einen Filter (6) und einen spannungsgesteuerten Oszillator (7) umfasst, um den Takt (C-clk) für den Client-IC (3) zu erzeugen, wobei die PLL-Stufe (4) mit dem Takt (H-clk) des Host-IC (2) für die reguläre Datenkommunikation über die verdrahtete Datenschnittstelle gesperrt sein muss, zu initialisieren, wobei das Verfahren die folgenden Schritte umfasst:
- Bereitstellen von Energie für den Host-IC (2) und den Client-IC (3);
- Verwenden des unregulierten Ausgabetakts (C-clk) des freilaufenden spannungsgesteuerten Oszillators (7) in einer Zeitspanne nach dem Einschalten für eine Einschalt-Datenkommunikation über die verdrahtete Datenschnittstelle, um Konfigurationsdaten von dem Host-IC (2) zu empfangen;
- Verwenden der Konfigurationsdaten, um den Client-IC (3) zu konfigurieren, den Takt des Host-IC (2) zu sperren, sowie den Client-IC (3) für die reguläre Datenkommunikation nach dieser Zeitspanne.

10. Verfahren gemäß Anspruch 9, wobei die Einschalt-Datenkommunikation die folgenden Schritte umfasst:
- Messen der Dauer einer Bit-Information, die von dem Host-IC (2) gesendet wird, mit dem unregulierten Ausgabetakt (C-clk) während der Einschalt-Datenkommunikation;
- Verwenden der gemessenen Dauer, um Konfigurationsdaten von dem Host-IC (2) während der Einschalt-Datenkommunikation zu empfangen;
- Konfigurieren des Client-IC (3) und insbesondere der PLL-Stufe (4) für die reguläre Datenkommunikation.

## Revendications

1. Système (1) d'un CI hôte (2) connecté via une interface de données câblée à un CI client (3) pour initier la communication entre le CI hôte (2) et le CI client (3) après une mise sous tension, dans lequel le CI client (3) comprend un étage PLL (4) avec une boucle fermée d'un détecteur de phase (5), un filtre (6) et un oscillateur commandé en tension (7) pour la génération de l'horloge (C-clk) pour le CI client (3), lequel étage PLL (4) doit être verrouillé à la horloge (H-clk) du CI hôte (2) pour une communication de données régulière via l'interface de données câblée, lequel système (1) est **caractérisé en ce que** le CI client (3) comprend un étage de mise sous tension (13) pour diriger un commutateur (14) dans la connexion entre l'entrée de l'horloge (H-clk) du CI hôte (2) pour l'étage PLL (4) et l'oscillateur commandé en tension (7) de l'étage PLL (4) pour ouvrir la connexion et utiliser l'horloge de sortie non régulée de l'oscillateur commandé en tension à fonctionnement libre (7) dans une période de temps après une mise sous tension pour une communication de données de mise sous tension via l'interface de données câblée et pour fermer le commutateur (14) après cette période de temps pour une communication de données régulière.

2. Système (1) selon la revendication 1, dans lequel l'étage de mise sous tension (13) est construit pour commander un étage décodeur/codeur (12) afin d'utiliser l'horloge de sortie non régulée pour mesurer la durée d'une information binaire envoyée par le CI hôte (2) pendant une communication de données de mise sous tension et pour utiliser la durée mesurée pour recevoir des données de configuration provenant du CI hôte (2) pendant la communication de données de mise sous tension et pour utiliser les données de configuration pour configurer le CI client (3) et en particulier l'étage PLL (4) pour la communication de données régulière avec le commutateur fermé (14) de l'étage PLL (4).

3. Système (1) selon la revendication 2, dans lequel les données de configuration sont utilisées pour régler le rapport d'un diviseur de fréquence (8) dans la boucle entre l'oscillateur commandé en tension (7) et le détecteur de phase (5) et/ou pour régler le rapport d'un diviseur de fréquence (9) de l'horloge de sortie de l'oscillateur commandé en tension (7) et/ou pour ajuster un oscillateur du CI client (3) et/ou pour sélectionner une horloge de référence et/ou pour prétraiter une horloge de référence sélectionnée.

4. Système (1) selon l'une quelconque des revendications 1 à 3, dans lequel l'interface de données câblées est réalisée sous la forme d'un UART et l'étage de mise sous tension (13) est construit pour détecter le premier front descendant ou montant du bit de départ ou tout autre motif de bit spécial pendant une communication de données de mise sous tension et pour compter le nombre de cycles d'horloge de l'horloge de sortie non régulée (C-clk) jusqu'au front montant ou descendant du bit de départ ou du motif de bit spécial, lequel nombre compté de cycles d'horloge est utilisé comme référence pour la longueur de bit ou la longueur de motif de bit spécial par un étage décodeur/codeur (12) du CI client (3) pour décoder les données de configuration reçues après le bit de départ ou le motif de bit spécial et/ou pour coder des données à transmettre au CI hôte (2) pendant la communication de données de mise sous tension.

5. Système (1) selon la revendication 4, lequel l'étage de mise sous tension (13) est construit pour comparer le nombre compté de cycles d'horloge avec un seuil supérieur et un seuil inférieur pour chacun d'un certain nombre de débits de en bauds possibles pour détecter le débit de en bauds utilisé par le CI hôte (2) et pour régler le débit en bauds détecté dans le CI client (3).

6. Système (1) selon la revendication 1, lequel étage de mise sous tension (13) est conçu pour commander l'ouverture du commutateur (14) et pour utiliser l'horloge de sortie non régulée de l'oscillateur commandé à fonctionnement libre (7) même après la communication de données de mise sous tension pour au moins une partie de la communication de données suivante via l'interface de données câblée.

7. Système (1) selon l'une quelconque des revendications 1 à 6, dans lequel le CI client (3) comprend une interface de données sans fil (10) pour communiquer avec un autre dispositif, laquelle communication sans fil ne démarre après que le commutateur (14) ait été fermé à nouveau et que l'horloge (C-clk) du CI client (3) ait été réglée par l'étage de mise sous tension (13).

8. Système (1) selon la revendication 6, ladite interface de données sans fil (10) est réalisée sous la forme d'une interface NFC qui satisfait à la norme IS018.092.

9. Procédé pour initialiser une communication de données régulière entre un circuit intégré hôte (2) connecté via une interface de données câblée à un CI client (3) après une mise sous tension, lequel CI client (3) comprend un étage PLL (4) avec une boucle fermée d'un détecteur de phase (5), un filtre (6) et un oscillateur commandé en tension (7) pour générer l'horloge (C-clk) pour le CI client (3), lequel étage PLL (4) doit être verrouillé à l'horloge (H-clk) du circuit intégré hôte (2) pour une communication de données régulière via l'interface de données câblée, lequel procédé comprend les étapes suivantes consistant à :
- fournir une alimentation au CI hôte (2) et au CI client (3) ;
- utiliser l'horloge de sortie non régulée (C-clk) de l'oscillateur commandé en tension à fonctionnement libre (7) dans une période de temps après une mise sous tension pour une communication de données sous tension via l'interface de données câblées pour recevoir des données de configuration à partir du CI hôte (2) ;
- utiliser les données de configuration pour configurer le CI client (3) afin de verrouiller l'horloge du CI hôte (2) et du CI client (3) pour une communication de données régulière après cette période de temps.

10. Procédé selon la revendication 9, dans lequel la communication de données de mise sous tension comprend les étapes suivantes consistant à :
- mesurer la durée d'une information binaire envoyée par le CI Hôte (2) avec l'horloge de sortie non régulée (C-clk) pendant une communication des données de mise sous tension ;
- utiliser la durée mesurée pour recevoir des données de configuration depuis le CI hôte (2) pendant une communication de données de mise sous tension ;
- configurer le CI Client (3) et notamment l'étage PLL (4) pour la communication de données régulière.
